# EUROPEAN PATENT APPLICATION

(11) **EP 1 936 670 A2**
(43) Date of publication of application: **25.06.2008**
(21) Application number: 07447070.9
(22) Date of filing: 21.12.2007
(51) Int. Cl.: H01L 21/20

(54) **Method to improve the Selective Epitaxial Growth (SEG) Process**

(30) Priority: 21.12.2006 EP 06126942; 20.07.2007 EP 07112851
(71) Applicant: Interuniversitair Microelektronica Centrum (IMEC), 3001 Leuven (BE)
(72) Inventor: Leys, Frederik, 9000 Gent (BE); Loo, Roger, 3010 Kessel-Lo (BE); Caymax, Matty, 3001 Leuven (BE)
(74) Representative: pronovem

(57) **Abstract**

The present invention is related to a method for producing a semiconductor device using a selective epitaxial growth (SEG) step comprising at least the following steps of:
- providing a semiconductor substrate;
- forming a pattern of an insulation material on said semiconductor substrate, thereby defining a covered and non covered surface;
- performing a cleaning step of said covered and non covered surface of said substrate having said insulating pattern defined;
- loading said substrate with said insulating pattern into a reaction chamber of an epitaxial reactor;
- starting a selective epitaxial growth comprising an injection of at least one semiconductor source gas with at least one first carrier gas in said reaction chamber of said epitaxial reactor;

characterized in that:
- prior to starting said selective epitaxial growth step, said surface of said substrate is subjected in said reaction chamber to an in situ pre-treatment with the injection of a halogen containing etching gas with a second carrier gas.

## Description

### Field of the Invention

The present invention is related to the field of semiconductor devices and the production thereof using methods of selectively forming epitaxial semiconductor layers.

More precisely, the present invention is related to improved methods for producing a semiconductor device using a selective epitaxial growth.

### Background of the Invention

Epitaxial growth is the process of depositing a thin layer (typically 0.5 to 20 microns) of single crystal material over a single crystal substrate, usually through chemical vapor deposition (CVD). Epitaxial growth is defined by some degree of matching between the crystalline structure of the grown/deposited layer and the crystalline structure of the substrate.

Semiconductor manufacturing widely uses CVD to deposit materials in various forms. For example in the semiconductor industry, CVD is a chemical process used to produce thin films of high-purity and high-performance solid materials. In a typical CVD process, the substrate is exposed to one or more volatile precursors (semiconductor source gasses) which react and/or decompose on the substrate surface to produce the desired thin film of the required material.

Low-temperature epitaxial depositions are very attractive in device fabrication to improve electrical performances of advanced complementary metal oxide semiconductors (CMOS) and bicomplementary metal oxide semiconductors (BiCMOS). CMOS is a major class of integrated circuits covering both digital logic and analog circuits.

In particular, Selective Epitaxial Growth (SEG) of silicon, silicon-germanium, pure germanium and III/V's such as GaAs and InGaAs plays an important role in the manufacturing of the very large scale integrated (VLSI) and the ultra large scale integrated (ULSI) circuits using three-dimensional bipolar, metal oxide semiconductors (MOS), bicomplementary metal oxide semiconductors (BiCMOS) and silicon-on-insulator (SOI) devices. Given a semiconductor substrate with a patterned structure defined in an insulating/dielectric mask material, SEG is a process in which the epitaxial growth of a semiconductor material occurs only on the exposed (non-covered) areas of the semiconductor substrate. The process is called 'selective' if no deposition/growth occurs on the areas covered with the insulator/dielectric mask. This technique has attracted considerable interest due to its potential for self aligned processing of very advanced devices. Some important applications of SEG are (i) the base layer stack in Heterojunction Bipolar Transistors in BiCMOS technology; (ii) Raised Source/Drain areas on bulk Si as well as on silicon-on-insulator (SOI) wafers; (iii) growth of Ge on Si or on Shallow Trench Isolation (STI) patterned Si wafers; (iv) growth of III/V on Ge or on STI patterned wafers. STI is an integrated circuit structure which prevents electrical current leakage between adjacent semiconductor device components.

SEG has been used for various deposition chemistries which can be divided into two classes, i.e. with and without the use of chlorine. Typically, unlimited SEG in chlorine free ambient is only possible for temperatures above 1100°C. Below this temperature invariably nucleation of Si on the insulator surface followed by poly-Si deposition will occur. Polysilicon deposition is the process of depositing a layer of polycrystalline silicon on a substrate.

Selectivity of the SEG process (which means that during the SEG the material is grown/deposited on the bare substrate but not on the insulator/dielectric material) at lower temperatures has only been shown in chlorine mixtures containing e.g. SiH4 and HCl, or SiH2Cl2 (DCS) with or without HCl, in which the chlorine component is able to etch away possible nuclei from the insulator surface before they can reach a critical size. In the case of absence of Si nucleation on the insulator surface, selectivity will be enhanced.

But, as underlined by Caymax et al. in the Proceedings of the 206th Meeting of the Electrochemical Society (Abs 1363, 2004), even with chlorine based chemistries full selectivity is not always guaranteed. In order to suppress Si nucleation, an etching gas (e.g. HCl) is added to the semiconductor source gas/precursor.

Etching is used in microfabrication to chemically remove layers from the surface of a wafer during manufacturing.

It is known that variations in previous processing (being e.g. variations in concentration of the chemical used during the wet cleaning step, variation in composition/stoichiometry of the deposited nitride layer material, contamination in general (moisture, organic, metals) originating from the wet chemistry or from the carrier gasses and process gasses) as well as variations in the composition of the insulator can lead to a selectivity loss. Any defects, contamination or irregularities on the insulator surface can induce Si nucleation. In order to compensate for the enhanced Si nucleation, higher flows of the etching gas might be needed, which at their turn have a negative effect on the growth rate and make the control of the process with respect to other unwanted effects (e.g. faceting) very difficult. This can cause important problems, especially in manufacturing.

Thus, as selectivity of the SEG process is influenced by the choice of the insulator material, the way this is deposited and by the steps prior to SEG, it can be desirable to provide a SEG process which is more robust towards variations in the steps prior to SEG and towards contaminations.

### Aims of the Invention

The present invention aims to provide an improved method, which does not present the drawbacks of prior art techniques, to produce a semiconductor device using a selective epitaxial growth.

In particular, the present invention aims to deal with the strong restriction on thermal budget of the SEG step for deep sub micron CMOS.

A preferred aim of the present invention is to provide a method of surface treatment of the semiconductor substrate, which renders a less reactive surface and, as such, maintains a broader process window for the selective epitaxial process.

As such, another aim of the present invention is to provide an improved method to give room for tuning with respect to faceting or to the difference in growth rate on n-type versus p-type implanted substrates.

### Main Characteristics of the Invention

The present invention aims to provide a method for improving the characteristics, i.e. enhancing the selectivity, of the selective epitaxial growth process.

The present invention more particularly aims to provide a method for producing a semiconductor device using a selective epitaxial growth (SEG) step comprising at least the following steps of:
- providing a semiconductor substrate;
- forming a pattern of an insulation material on said semiconductor substrate, thereby defining a covered and non covered surface;
- loading said substrate with said insulating pattern into a reaction chamber of an epitaxial reactor;
- starting a selective epitaxial growth comprising an injection of at least one semiconductor source gas possibly with at least one first carrier gas in said reaction chamber of said epitaxial reactor.

According to the present invention, said process is characterized by the fact that prior to starting said selective epitaxial growth step, said surface of said substrate is subjected in said reaction chamber to an in situ pre-treatment with the injection of a halogen containing etching gas, possibly with a second carrier gas.

More preferably, according to the present invention, prior to the step of loading said substrate in an epitaxial reactor, said substrate is submitted to a cleaning step.

More preferably, said cleaning step comprises a wet clean treatment and/or a wet etch treatment.

Preferably, said semiconductor substrate is selected from the group consisting of a single crystalline silicon substrate, a single crystalline germanium substrate, a single crystalline silicon germanium substrate, a single crystalline silicon germanium carbide substrate, a single crystalline silicon carbide substrate or a silicon-on-insulator (SOI) substrate.

Preferably, said insulation material is a dielectric material, preferably silicon dioxide (SiO2) or silicon nitride (Si3N4).

Preferably, said main semiconductor source gas is selected from the group consisting of a silicon source gas, a germanium source gas, a silicon germanium source gas, a III/V source gas, a carbon source gas or a source gas selected from the group of germyl-silane gasses or a mixture thereof.

Preferably, said halogen containing etching gas is an etching gas of one halogen element such as Cl or F. Example of such etching gas can be HCl or Cl2.

Preferably, said halogen containing gas is an etching gas being a mixture of gases of the same halogen element such as a mixture of HCl and C12.

Preferably, said halogen containing gas is a F or Cl containing gas and more preferably a Cl containing gas such as a HCl gas, a C12 gas, a diluted HCl gas, a diluted C12 gas or any other fluor-containing gas or a mixture thereof.

Preferably, said halogen containing etching gas does not contain any extra reactant element and in particular does not contain or comprise any reactant element which does not comprise the said halogen.

More preferably, said first and/or second carrier gasses are a H2 gas or an inert gas.

According to a preferred embodiment, the injection of said halogen containing etching gas is at least once performed prior to said injection of said at least one semiconductor source gas; said injection of said halogen containing etching gas is continued without interruption while performing said injection of said at least one semiconductor source gas.

According to another preferred embodiment, the injection of said halogen containing etching gas is at least once performed prior to said injection of said at least one semiconductor source gas; said injection of said halogen containing etching gas is stopped and resumed with performing said injection of said at least one semiconductor source gas.

According to another preferred embodiment, both said injection of said at least one semiconductor source gas and said injection of said halogen containing etching gas are performed repeatedly.

Preferably, said in situ pre-treatment with said halogen containing etching gas performed prior to said selective epitaxial growth step is preceded by an in situ H2 thermal anneal.

More preferably, the temperature of said in situ H2 thermal anneal is higher than the temperature of said in situ pre-treatment with said halogen containing etching gas.

More preferably, said in situ H2 thermal anneal is performed at a temperature range between 700°C and 900°C and more preferably between 700°C and 850°C.

According to a preferred embodiment, the temperature of said in situ pre-treatment with said halogen containing etching gas is higher than the temperature of said selective epitaxial growth step.

According to another preferred embodiment, the temperature of said in situ pre-treatment with said halogen containing etching gas is lower than the temperature of said selective epitaxial growth step.

Preferably, said selective epitaxial growth step is performed at a temperature comprised within the range of 500 to 900°C.

Preferably, said selective epitaxial growth is performed either at reduced pressure (LPCVD) or at atmospheric pressure.

More preferably, the in situ pre-treatment with said halogen containing etching gas is performed at a temperature comprised between the range of 500 to 900°C and more preferably within the range of 550 to 750°C.

More preferably, the temperature of said in situ pre-treatment with said halogen containing etching gas is lower than 900°C.

More preferably, the minimum duration of said in situ pre-treatment with said halogen containing etching gas is at least 1 second and more preferably at least 1 minute.

Preferably, the in situ pre-treatment with said halogen containing etching gas is performed during at least 30 seconds and more preferably during a period of time comprised between 1 and 10 minutes, preferably comprised between 1 and 8 minutes, and more preferably between 2 and 4 minutes.

Advantageously, the temperature and the duration of said treatments should be specified in order that the amount of etching required during said in situ pre-treatment with said halogen containing etching gas is less then or equivalent to the etching of 0.5 to 10 Å of semiconductor material.

Preferably, during the pre-treatment less than 10 Angstrom and more preferred less than 5 Angstrom of semiconductor material may be removed from the non covered surface.

### Definitions

The word "in situ" as used in the present invention means inside the reaction chamber of the epitaxial reactor.

"Insulating" as used in the present invention is the property of preventing the passage of electricity by surrounding with a nonconductive material.

The term "insulator" as used in the present invention is a material that insulates, i.e. a nonconductor of electricity.

A "dielectric" material as used in the present invention means a nonconductor of electricity.

It is to be understood that in the present invention, the terms "insulator" and "dielectric" are equivalent.

The word "injection" as used in the present invention means the act of starting to inject a gas and continuing this injection during a certain time interval.

It is to be understood that a time interval is defined by a definite start and end time.

### Brief Description of the Drawings

Figure 1 is describing the process sequence with an in situ (HCl) pre-treatment prior to the injection of the semiconductor source gas in the reaction chamber wherein steps III-V are performed in the epi-reactor.

Figure 2 is describing the summary of the time schedule for different embodiments of the present invention.

Figure 3 is representing the measurements of the haze according to different HCl in situ pre-treatment times.

### Detailed Description of several embodiments of the Invention

The object of the current invention will be further described in detail, making use of non-limiting examples and drawings.

In one aspect the present invention is directed to a method of fabricating a semiconductor device such as a CMOS device. A non-single crystalline pattern is formed on a single crystalline semiconductor substrate. In the case of a CMOS, an insulating spacer is formed on side walls of the non-single crystalline semiconductor pattern.

A surface of the substrate having the insulating spacers defined may be cleaned and subjected to a wet etch treatment in order to remove the native oxide prior to introduction in the reaction chamber. This treatment which is a cleaning and/or wet etch treatment is needed immediately prior to the epitaxial growth, as native oxide is growing on the (bare) substrate when exposed to ambient atmosphere.

The wet etch treatment, e.g. a dilute HF step, enhances the reactivity of the insulating material, leading to a selectivity loss during the selective epitaxial growth. After clean (wet etch) treatment the substrate with the insulating spacer(s) is loaded into the reaction chamber of an epitaxial apparatus.

A first anneal step is then optionally applied to the substrate. The anneal step is performed by injecting a carrier gas in the reaction chamber. Hydrogen may be employed as a carrier gas and the annealing step is preferably performed at a temperature between 700°C and 900°C.

Next, after the anneal step is finished, an in situ pretreatment with an etching gas is performed. The etching gas is injected in the reaction chamber prior to the injection of the semiconductor source gas, thereby compensating for the enhanced reactivity of the insulating material. The selective epitaxial growth starts when at least one semiconductor source gas is injected into the reaction chamber. The etching gas may be continuously supplied, without interruption, during the in situ pre-treatment and the selective epitaxial growth, but the flow rates used may be different according to the process.

In one embodiment, the spacers comprise typically a silicon based dielectric material such as silicon oxide or silicon nitride.

In some embodiments, the single crystalline semiconductor substrate may be one of the following substrates: Si, Ge, SiGe, SiGeC and SiC with different compositions or silicon-on-insulator (SOI) substrate.

In other embodiments the non-single crystalline semiconductor dielectric pattern may be formed of an amorphous semiconductor layer or a polycrystalline semiconductor layer. The amorphous semiconductor layer or a polycrystalline semiconductor layer may be a silicon layer, a germanium layer, a silicon germanium layer or a metal gate material.

In other preferred embodiments, the etching gas may contain halogen elements which react with the atoms of the epitaxial semiconductor layer and which are not able to etch the bulk insulator material. Consequently, the in situ treatment will have an effect only on a very thin surface layer of the insulating material. The etching gas containing halogen may be an HCl gas, a Cl2 gas, a diluted HCl or a diluted Cl2 gas. The diluted HCl gas may be a mixture of HCl and H2 gas or a mixture of HCl and an inert gas (e.g. Ar or He). The diluted Cl2 gas may be a mixture of C12 and H2 gas or a mixture of Cl2 and an inert gas (e.g. Ar or He).

In a further embodiment, the semiconductor source gas may be one of the silicon source gas, a germanium source gas and a silicon germanium or III/V or mixtures thereof. The silicon source gas may be one of a silane (SiH4) gas, a disilane (Si2H6) gas, a dichlorosilane (SiH2Cl2) gas, a SiHCl3 gas and a SiCl4 gas and the germanium source gas may be a GeH4 gas. The silicon germanium source gas may comprise the silicon source gas and the germanium source gas. The semiconductor source gas may be also one of the more advanced gases from the family of germyl-silanes, e.g. H3GeSiH3, (H3Ge)2SiH2, (H3Ge)3SiH, (H3Ge)4Si or may comprise a carbon source gas for the growth of SiC and SiGeC. The carbon source gas may be C2H6 gas or CH3SiH3 gas. The semiconductor source gas may also contain a doping gas like phosphine (PH3) for n-type doping or diborane (B2H6) for p-type doping.

It is noticed that besides the choice of the insulator material (e.g. SiO₂, Si₃N₄, SiC or a polymeric material) and the way this is deposited, the process steps prior to SEG, like cleaning and diluted HF-dip can have an important influence on the selectivity of the SEG process.

The strong restriction on thermal budget of the selective epitaxial growth step for deep sub micron CMOS processing imposes the use of an HF-dip to remove most of the native oxide prior to deposition. As a negative side-effect, the HF-dip makes the surface of the insulating material more reactive, and this narrows the process window in which the deposition is selective. The enhanced reactivity is observed for insulation material such as silicon nitride and silicon oxide.

In particular in the case of the silicon nitride it is noticed that the cleaning treatment followed by a diluted HF step to remove the native oxide, performed prior to epitaxial growth, make the Si₃N₄ surface more reactive leading to selectivity loss during SEG. More specific, it is observed that on diluted HF treated Si₃N₄ surfaces more nucleation takes place than on the not-cleaned surfaces. The enhanced number of nuclei formed is a direct measure of the reactivity of the surface.

The enhanced reactivity of a nitride surface after HF is observed through the following experiment: a very short deposition is done with dichlorosilane (DCS) on a nitride surface. DCS is a Si precursor gas that is nearly selective without the addition of extra HCl, because it contains Cl. Because the deposition time is very short, only discrete nuclei are formed on the nitride surface instead of closed layers. The number of nuclei formed, for a fixed deposition time, can be counted and it is a direct measure for the reactivity of the surface and of the condition of the reactor gasses and tubes.

Using this method, an increase in the number of nuclei by at least an order of magnitude is observed when the nitride surface is subjected to an HF-dip prior to the DCS deposition.

The enhanced reactivity of nitride is illustrated by the following experiment: 3 silicon wafers are first deposited with 20 nm PECVD nitride and then subjected to a standard SC1 clean, consisting of ammonium peroxide mixture H4OH/H2O2/H2O = 1:1:5, followed by DI rinse and drying.

All the wafers are loaded for a short deposition with DCS in the epitaxial (epi) reactor. Prior to the epitaxial growth step, wafers 2 and 3 received an extra HF-dip treatment for 30 sec in HF 2%. Wafer 3 received prior to the DCS deposition an in situ HCl pre-treatment in the epi reactor. Table 1 summarizes the results of the particle measurement before and after the epi deposition in all these cases.

Before deposition all the wafers show similar levels of light point defects (LPD). Their distribution over the different bins (where a bin is referring to a specific range in the particle size distribution based upon the particle diameter) is identical and the haze (being the background scattering information given by a particle measurement tool, which provides a measure of the surface small scale variations, e.g. the presence of small particles with a diameter lower than 50 nm) shows similar values, as can be seen in Table 1. For all the 3 wafers, about 250 counts are measured for bin 1, corresponding to LPD with a diameter higher than 0.1 microns, and the haze show values under 0.15 ppm.

After deposition, the number of LPD in bin 1 is much higher on wafers 2 and 3, which have both undergone a diluted HF-dip before deposition. In case of wafer 2, both bin 1 and bin 2 are saturated and the average haze is about 8.089 ppm, indicating the presence of a high number of small nuclei on the nitride surface.

Wafer 3, which received first a diluted HF-dip followed by an in situ HCl pre-treatment in the epi reactor, prior to the DCS deposition, shows a significant reduction in the number of LPD after deposition: the haze has dropped with about 30% and the bin 2 value (LPD with a diameter > 0.150 microns) shows a drop from 20802 to 530, which is actually similar with the value on wafer 1. The enhanced reactivity of the nitride surface was in this case diminished by the in situ HCl pre-treatment.

Therefore is concluded that an in situ HCl pretreatment prior to SEG process restores the stoichiometry of the nitride top surface layers, initially affected by the diluted HF treatment.

Moreover, the SEG process becomes more robust, since the in situ HCl treatment can compensate for other variations in the process parameters.

For example, values lower than the critical value can be used for the (HCl) etching gas flow added during the SEG process. The critical value refers to a minimum etching gas flow rate needed without in situ HCl pretreatment to have enough selectivity towards nitride. Another advantage of the in situ HCl pretreatment is that by lowering the etching gas (HCl) flow rates it gives more room for tuning the process with respect to faceting or the difference in growth rate on n versus p-type implanted substrates.

At the same time, by introducing the in situ HCl pretreatment, the SEG process becomes more robust towards variability introduced by cleaning, variations in the stoichiometry of the deposited nitride layer, metal or moisture contamination from the carrier gasses/process gasses or from the cleaning bath.

Further, by etching a superficial highly doped layer, a reduction in the difference between the growth rates on n and p-type semiconductor substrates may be achieved.

Most probably a thin oxide layer is present on top of the nitride layer on the as-deposited layer prior to HF-dip, which is actually confirmed by XPS measurements. The thin oxide layer is removed almost completely by the HF-dip, which leads implicit to a selectivity loss during SEG, since it is known that selectivity towards oxide is better than towards nitride.

In a preferred embodiment, the process flow comprises at least the following steps:
(I) wet clean, which may be a SC1 clean (commonly known as the first step of the standard RCA clean) ;
(II) diluted HF treatment (dip), typically 30 sec in HF 2%;
(III) thermal annealing in H2 atmosphere at a temperature between 700-900°C for 1-10 minutes
(IV) in situ HCl pre-treatment at a temperature between 500-900°C, using flows between with 50-100 sccm HCl flow, diluted in 20-40 slm hydrogen; the etch time may be between 2 and 4 minutes;
(V) selective epitaxial growth by supplying simultaneously an etching gas (e.g. HCl) and at least one source gas (e.g. SiH4, SiCl2H2).

These steps are preferably consecutive steps.

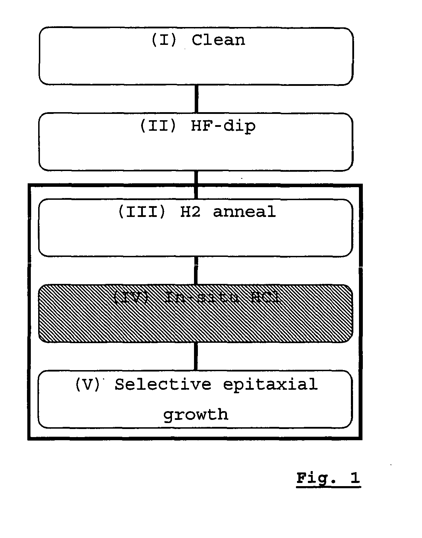

The in situ HCl pre-treatment (step IV in the above scheme and in Figure 1) is performed prior to the selective epitaxial growth (V) and may be preceded, optionally, by an in situ H2-anneal (III). Steps (I) and (II) are wet processing operations preferably outside the epi-reactor. Steps (III) to (V) are performed in situ in the epi-reactor.

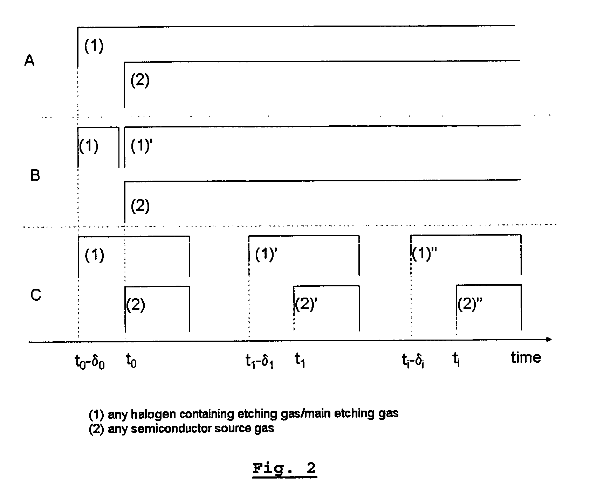

Figure 2 is showing that the in situ HCl pre-treatment is performed immediately prior to the injection of at least one semiconductor source gas. According to the present invention, said injection of the etching gas (HCl) starts with a time interval δ0 before the injection of the at least one semiconductor source gas (t0).

According to a preferred embodiment described in Figure 2A, said injection of the etching gas (HCl) continues without interruption after the injection of the at least one semiconductor source gas.

According to another embodiment described in Figure 2B, the injection of the etching gas (HCl) starts with a time interval δ0 before the injection of the at least one semiconductor source gas (t0) but is then stopped and resumed with the injection of the at least one semiconductor source gas.

In the case of Figure 2(B) the deposition temperature of the epitaxial step should be lower than the in situ pre-treatment temperature to prevent the desorption of the halogen species and maintain the passivation effect.

Figure 2C is describing the case of multiple steps (n) deposition wherein the injection of the etching gas (HCl) starts every time with a time interval δi before the injection of the at least one semiconductor source gas (ti, i = 0-n). In the case of Figure 2(C) the deposition step (i) can start immediately after the deposition step (i-1) has been finished.

The temperature of injecting the halogen containing etching gas during steps (1), (1)' or (1)'' compared to the temperature of injecting any semiconductor source gas during steps (2), (2)' or (2)" may be identical or different, higher or lower.

The halogen containing etching gasses during steps (1), (1)' and (1)'' may be identical or different, higher or lower, as well as the semiconductor source gasses during steps (2), (2)' and (2)".

During the injection of any semiconductor source gas during steps (2), (2)' or (2)", the gas during steps (1), (1)' or (1)'' is serving as main etching gas.

In a preferred embodiment, the in situ (HCl) pre-treatment described in steps (1), (1)' and (1)'' corresponding to step IV of Figure 1 may be performed at a temperature between 500-900°C, more preferred between 500-850°C and even more preferred between 550-750°C.

In a preferred embodiment, the temperature of the in situ (HCl) pre-treatment described in steps (1), (1)' and (1)'' corresponding to step IV of Figure 1 should be lower than 900°C to prevent the desorption of the Cl-passivating species.

In a preferred embodiment, the in situ (HCl) pre-treatment described in steps (1), (1)' and (1)'' corresponding to step IV of Figure 1 has a duration of at least 30 seconds and is preferably comprised between 1 and 10 minutes, more preferably between 1 and 8 minutes, and even more preferably between 2 and 4 minutes.

In another preferred embodiment, the minimum duration of the in situ (HCl) pre-treatment described in steps (1), (1)' and (1)'' corresponding to step IV of Figure 1 is at least 1 second and preferably at least 1 minute.

The amount of etching required during the in situ pretreatment is less then or equivalent to the etching of 0.5 Å - 2 Å of semiconductor material, which is compatible with the most advanced process flow.

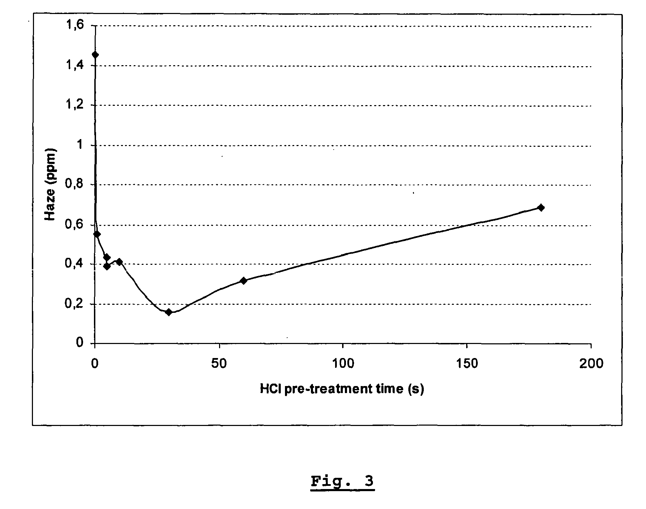

Table 2 and Figure 3 are showing that an HCl pre-treatment (performed on diluted HF treated nitride surfaces) of 1 second already leads to an improvement of the initial haze value of the surface (being the measure of the number of nuclei with a diameter smaller than 50 nm formed on the nitride surface upon a short deposition with dichlorosilane (DCS)). The haze value is further improving with increasing pre-treatment time, the lowest value being obtained after 30 seconds. Increasing the HCl flow (for a given pre-treatment time) also improves the haze value.

The beneficial effect obtained can be explained either (1) by the fact that C1 passivates the surface dangling bonds present on the nitride surface after removing a very thin oxide layer by diluted HF or (2) by the fact that diluted HF leaves a Si-rich surface by preferentially etching the N; while the in situ HCl treatment etches the superfluous Si and restores the surface stoichiometry.

**Table 1: Particle number before and after deposition measured on LPCVD nitride.**

| Wafer no | Treatment Sequence | Before deposition | | | | After deposition | | | |
|---|---|---|---|---|---|---|---|---|---|
| | | Bin1 LPD> 0.100 um | Bin2 LPD> 0.150um | Bin3 LPD> 0.200um | Haze (ppm) | Bin1 LPD> 0.100um | Bin2 LPD> 0.150um | Bin3 LPD >0.200um | Haze (ppm) |
| Wafer 1 | SC1 clean | 253 | 78 | 23 | 0.140 | 3533 | 389 | 32 | 3.419 |
| Wafer 2 | SC1 clean + HF-dip | 229 | 139 | 109 | 0.057 | 69999 | 20802 | 105 | 8.089 |
| Wafer 3 | SC1 clean + HF-dip + HCl-preclean | 252 | 57 | 30 | 0.057 | 48868 | 530 | 63 | 5.980 |

**Table 2: Measurement of the haze (reflecting number of nuclei with diameter smaller than 50 nm) according to different HCl in situ pretreatment times.**

| HCl pre-treatment time (s) | HCl flow (sccm) | Haze (ppm) | LPD (0.100-0.150µm) |
|---|---|---|---|
| 0 | 0 | 1,456 | 61471 |
| 1 | 50 | 0,553 | 202 |
| 5 | 50 | 0,431 | 186 |
| 5 | 100 | 0,388 | 374 |
| 10 | 50 | 0,409 | 396 |
| 30 | 50 | 0,156 | 399 |
| 60 | 50 | 0, 316 | 1984 |
| 180 | 50 | 0,685 | 2769 |

## Claims

1. A method for producing a semiconductor device using a selective epitaxial growth (SEG) step comprising at least the following steps of:
- providing a semiconductor substrate;
- forming a pattern of an insulation material on said semiconductor substrate, thereby defining a covered and non covered surface;
- performing a cleaning step of said covered and non covered surface of said substrate having said insulating pattern defined;
- loading said substrate with said insulating pattern into a reaction chamber of an epitaxial reactor;
- starting a selective epitaxial growth comprising an injection of at least one semiconductor source gas with at least one first carrier gas in said reaction chamber of said epitaxial reactor;
**characterized in that**:
- prior to starting said selective epitaxial growth step, said surface of said substrate is subjected in said reaction chamber to an in situ pre-treatment with the injection of a halogen containing etching gas with a second carrier gas.

2. A method according to claim 1, wherein said halogen containing etching gas is an etching gas of one halogen element such as e.g. HCl or C12.

3. A method according to claim 1, wherein said halogen containing gas is an etching gas being a mixture of gases of the same halogen element such as e.g. a mixture of HCl and C12.

4. A method according to any one of the preceding claims, wherein said halogen containing etching gas is selected from the group consisting of a HCl gas, a C12 gas, a diluted HCl gas or a diluted C12 gas or a mixture thereof.

5. A method according to claim 4, wherein said diluted HCl gas is a mixture of HCl and H2 gas or a mixture of HCl and an inert gas.

6. A method according to claim 4, wherein said diluted C12 gas is a mixture of C12 and H2 gas or a mixture of C12 and an inert gas.

7. A method according to any one of the preceding claims, wherein said semiconductor substrate is selected from the group consisting of a single crystalline silicon substrate, a single crystalline germanium substrate, a single crystalline silicon germanium substrate, a single crystalline silicon germanium carbide substrate, a single crystalline silicon carbide substrate or a silicon-on-insulator (SOI) substrate.

8. A method according to any one of the preceding claims, wherein said insulation material is a dielectric material, preferably silicon dioxide (SiO2) or silicon nitride (Si3N4).

9. A method according to any one of the preceding claims, wherein said cleaning step comprises a wet clean treatment and/or a wet etch treatment.

10. A method according to any one of the preceding claims, wherein said main semiconductor source gas is selected from the group consisting of a silicon source gas, a germanium source gas, a silicon germanium source gas, a III/V source gas, a carbon source gas or a source gas selected from the group of germyl-silane gasses or mixtures thereof.

11. A method according to any one of the preceding claims, wherein said first and/or second carrier gasses is a H2 gas or an inert gas.

12. A method according to any one of the preceding claims, wherein the injection of said halogen containing etching gas is at least once performed prior to said injection of said at least one semiconductor source gas; said injection of said halogen containing etching gas is continued without interruption while performing said injection of said at least one semiconductor source gas.

13. A method according to claim 10, wherein both said injection of said at least one semiconductor source gas and said injection of said halogen containing etching gas are performed repeatedly.

14. A method according to claim 1 to 11, wherein the injection of said halogen containing etching gas is at least once performed prior to said injection of said at least one semiconductor source gas; said injection of said halogen containing etching gas is stopped and resumed with performing said injection of said at least one semiconductor source gas.

15. A method according to any one of the preceding claims, wherein said in situ pre-treatment with said halogen containing etching gas performed prior to said selective epitaxial growth step is preceded by an in situ H2 thermal anneal.

16. A method according to claim 15, wherein the temperature of said in situ H2 thermal anneal is higher than the temperature of said in situ pre-treatment with said halogen containing etching gas.

17. A method according to any one of the preceding claims, wherein said in situ pre-treatment with said halogen containing etching gas is performed at a temperature range between 500°C and 900°C.

18. A method according to claim 17, wherein said in situ pre-treatment with said halogen containing etching gas is performed at a temperature range between 550°C and 750°C.

19. A method according to any one of the preceding claims, wherein said in situ pre-treatment with said halogen containing etching gas is performed during at least 1 second.

20. A method according to any one of the preceding claims, wherein the duration of said in situ pre-treatment with said halogen containing etching gas is at least 30 seconds.

21. A method according to claim 20, wherein said duration of said in situ pre-treatment with said halogen containing etching gas is at least 1 minute.

22. A method according to any one of the preceding claims, wherein said in situ pre-treatment with said halogen containing etching gas is performed during a period of time comprised between 1 and 10 minutes.

23. A method according to claim 22, wherein said in situ pre-treatment with said halogen containing etching gas is performed during a period of time comprised between 1 and 8 minutes.

24. A method according to claim 23, wherein said in situ pre-treatment with said halogen containing etching gas is performed during a period of time comprised between 2 and 4 minutes.

25. A method according to any one of the preceding claims, wherein the amount of etching required during said in situ pre-treatment with said halogen containing etching gas is less then or equivalent to the etching of 0.5 to 10 Å of semiconductor material.
